Europäisches Patentamt

European Patent Office

Office européen des brevets

(19)

(11) Publication number: **0 265 348**
**A2**

(12)

# EUROPEAN PATENT APPLICATION

(21) Application number: **87402400.3**

(22) Date of filing: **23.10.87**

(51) Int. Cl.4: **G 06 K 19/06**
**G 06 K 7/06**

(30) Priority: **24.10.86 JP 253277/86**
**11.11.86 JP 268090/86**

(43) Date of publication of application:
**27.04.88 Bulletin 88/17**

(84) Designated Contracting States:
**CH DE FR GB IT LI**

(71) Applicant: **DAIICHI DENSHI KOGYO KABUSHIKI KAISHA**
**7-12, Yoyogi 2-chome Shibuya-ku**
**Tokyo (JP)**

(72) Inventor: **Ohtsuki, Tomonari**
**109, Takase-Cho 2-Chome**
**Mooka City Tochigi Pref. (JP)**

(74) Representative: **Phélip, Bruno et al**
**c/o Cabinet Harlé & Phélip 21, rue de la Rochefoucauld**
**F-75009 Paris (FR)**

(54) IC card and connector therefor.

(57) An IC card includes a plurality of terminals on both surfaces at one edge of the card. The terminals on one surface are arranged between terminals on the other surface. The adjacent terminals on each surface are in a relation $P/2 > W$, where W is a width of the terminals and P is a distance between centers of the terminals. The front ends of the terminals are narrowed in width or retracted from the edge of the card inside thereof to make longer surface insulating distances between the terminals on both the surfaces. A connector for an IC card includes a connector body having two side walls extending from the connector body to form a guide for the IC card to be inserted into the connector and a plurality of contacts planted in two parallel rows in the connector body. The contacts arranged in one row are between contacts arranged in the other row and the contacts are planted to be deformed before insertion of the IC card to cause contact pressures required for electrical connection with the IC card.

EP 0 265 348 A2

**Description**

## IC CARD AND CONNECTOR THEREFOR

This invention relates to an IC card and a connector for the IC card, and more particularly to an IC card of an insert type which is very thin and has terminals on both surfaces, and a connector for such a thin IC card.

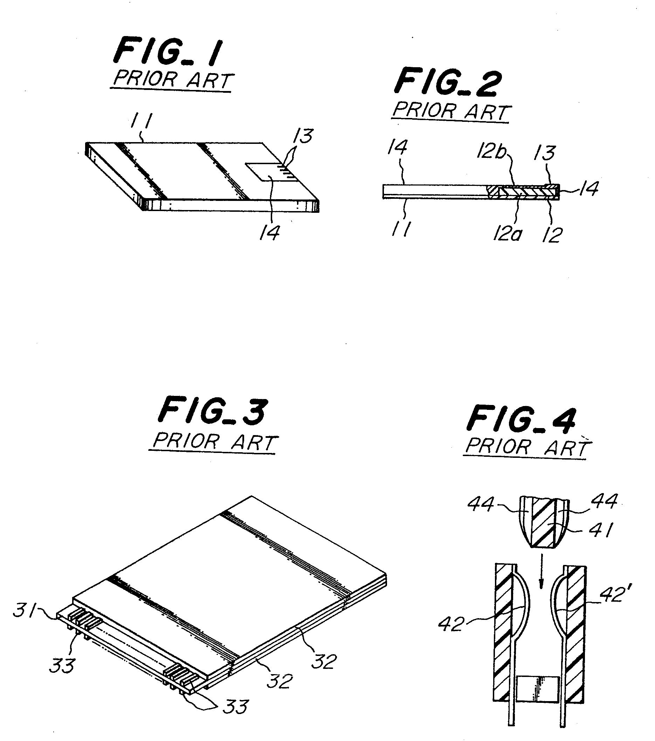

With the development of the integrated circuit (referred to hereinafter "IC") technique, IC cards have appeared instead of magnetic cards and have been progressively practically used. There are two kinds of IC cards. One is provided on an edge of the card with contacts for connecting with an electronic computer or its console unit, and the other is provided with contacts at a center of one surface of the card. Fig. 1 illustrates an example of the former, wherein a card body 11 has four contacts 13 which are representative of a ground terminal, a power source terminal, a signal input terminal and a signal output terminal. Referring to Fig. 2 illustrating an outline of the construction of the IC card shown in Fig. 1, the card body 11 has a discrimination unit 12 which is an IC chip comprising a substrate 12a of Si, Ge or the like and an IC 12b embedded therein. Moreover, contacts 13 are provided by vapor deposition, welding or the like for connecting with an external circuit. Reference numeral 12 denotes a cover for covering the discrimination unit to prevent it from being damaged.

Furthermore, there is an IC card having contacts on both surfaces as shown in Fig. 3. Referring to Fig. 3, the IC card has a base 31 whose one side is provided with contacts 33 for connecting to an external circuit. The remaining part of the base 31 other than the side is covered with covers 32 to prevent the base from being damaged.

With the development of the IC technique in recent years, circuits to be carried on IC cards have been further integrated and the number of contacts for connecting with external circuits has been increased. Therefore, contacts provided only on one surface of the card do not meet needs of contacts, and contacts are further provided on the other surface of the card.

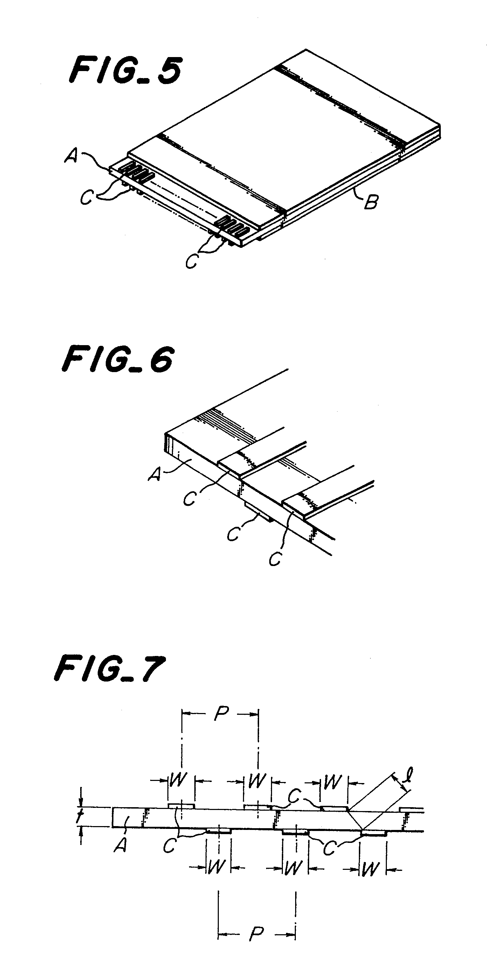

With a prior art connector for the IC card having the contacts on both the surfaces as above described, contacts 42 and 42′ are arranged in close opposition to each other without contacting as shown in Fig. 4. An IC card 41 is inserted between the contacts 42 and 42′ to embrace the IC card 41 having contact portions 44 by the contacts 42 and 42′, thereby causing a contact pressure to achieve an electric connection.

With the development of the IC technique, the IC chip has been further thinned. An IC chip having a thickness less than 0.8 mm has been realized and the IC card itself has been expected to have a thickness less than 1.0 mm.

On the other hand, however, the fact that an IC card having contacts on both sides is very thin means that distances between terminals on both sides are very short. Therefore, there has been a problem that insulation distances required between terminals on both sides cannot be sufficiently obtained.

In the system of obtaining the contact pressure resulting from elastic deformations of contacts of a connector caused by the insertion of the IC card as in the prior art, when an IC card having a thickness less than 1 mm is inserted, it cannot cause in the contacts contacting pressures required for electric connections so that reliable electric connections could not be expected.

It is a principal object of the invention to provide an IC card and a connector for the card which eliminate all the disadvantages of the prior art.

It is another object of the invention to provide a thin IC card which completely prevents any dielectric breakdown between terminals on both surfaces of the card even it is very thin, and to provide an improved connector suitable for such a very thin IC card.

In order to achieve these objects, in an IC card including a plurality of terminals on both surfaces at one edge of the card according to the invention, terminals on one surface are arranged between terminals on the other surface.

In a preferred embodiment, adjacent terminals on each surface are in a relation $P/2 > W$, were W is a width of the terminals and P is a distance between centers of the terminals.

In another embodiment, front ends of the terminals are narrowed in width or retracted from the edge of the card inside thereof to make longer surface insulating distances between the terminals on both the surfaces.

In another aspect, in a connector for an IC card including a connector body having two side walls extending from the connector body to form a guide for the IC card to be inserted into the connector and a plurality of contacts planted in two parallel rows, according to the invention contacts arranged in one row are between contacts arranged in the other row and the contacts are planted to be deformed before insertion of the IC card to cause contact pressures required for electrical connection with the IC card.

In a preferred embodiment, the connector body is formed in two rows with contact providing apertures whose number corresponds to that of the contacts so that the contact providing apertures in one row are between the contact providing apertures in the other row, and the side walls are formed in two rows with contact receiving grooves at locations corresponding to the contact providing apertures.

With the above arrangement, the surface insulating distances become longer to make it possible to use a thinner base plate and hence to provide a thinner IC card. As the surface insulating distances are longer, there is no longer any dielectric breakdown or discharge between the terminals on both the surfaces, even if a thickness of the base plate of the card is of the order of 0.1 mm, thereby providing high reliable IC cards.

With the connector for the IC card according to the invention, contact pressures required for electrical connections are already reserved in the contacts of the connector, so that even if an IC card to be inserted is very thin, the required electrical connection is ensured to provide a reliable connector.

In order that the invention may be more clearly understood, preferred embodiments will be described, by way of example, with reference to the accompanying drawings.

Figs. 1-3 illustrate an IC card of prior art;

Fig. 4 is a sectional view illustrating a connector of the prior art for an IC card;

Fig. 5 is a perspective view schematically illustrating an IC card according to the invention;

Fig. 6 is a partially enlarged perspective view illustrating contacts of the IC card according to the invention;

Fig. 7 is a front elevation of the IC card according to the invention for explaining its operation;

Figs. 8a and 8b illustrate modifications of the IC card according to the invention;

Fig. 9 is a graph for explaining the principle of the invention;

Fig. 10 is a perspective view, partially removed, of a connector according to the invention;

Fig. 11 is a plan view of the connector shown in Fig. 10; and

Figs. 12 and 13 are sectional views taken along lines XII-XII and XIII-XIII in Fig. 10.

Fig. 5 illustrates an IC card according to the invention which comprises a base A, covers B and a plurality of terminals C provided on both surfaces of the base as shown in its appearance in the drawing. Most of actually used IC cards have lengths of 75-125 mm, widths of 50-75 mm and thicknesses of 0.5-5 mm. A shutter is often provided on an IC card for dust-proof and preventing electromagnetic jamming.

The terminals C of the IC card according to the invention are arranged on both the surfaces of the base A such that the terminals on the one surface are positioned between the terminals on the other surface. So long as a mechanical strength required for a card is fulfilled, a thickness of the base A is made as thin as possible which is generally of the order of 0.1-1 mm depending upon a material of the base A. A material of the base A is not limited to a particular one. Various materials for the base may be used such as a plate of a thermoplastic resin, for example, polypropylene, polyethylene terephthalate, polybutylene terephthalate, polyamide (nylon), polycarbonate, polyvinyl chloride or the like, or laminated plates impregnated with a thermosetting resin such as phenol resin, urea resin, melamine resin, unsaturated polyester resin, epoxy resin or the like, or a metal plate of aluminum, stainless steel, copper or the like or such a metal plate coated with insulating layer or the like. Moreover, a circuit may be often provided directly on the base A.

As shown in Figs. 6 and 7, according to the invention, a plurality of the terminals provided on both the surfaces of the base A of the IC card are arranged in a relation of $P/2 > W$, where W is the width of the terminals and P is the distance between centers of the terminals. With this arrangement, the terminals arranged on both the surfaces are not overlapped, and an insulating distance $\ell$ between the terminals is not less than a thickness t of the base A.

A material of the terminals of the IC card according to the invention may be any materials publicly known for electronical contacts, for example, copper, a copper alloy (phosphor bronze, brass, beryllium-copper, Tando (JIS H3100), cadmium copper, German silver and Cu-Ni-Sn) or the like. If required, gold or nickel plating may be applied to the terminals.

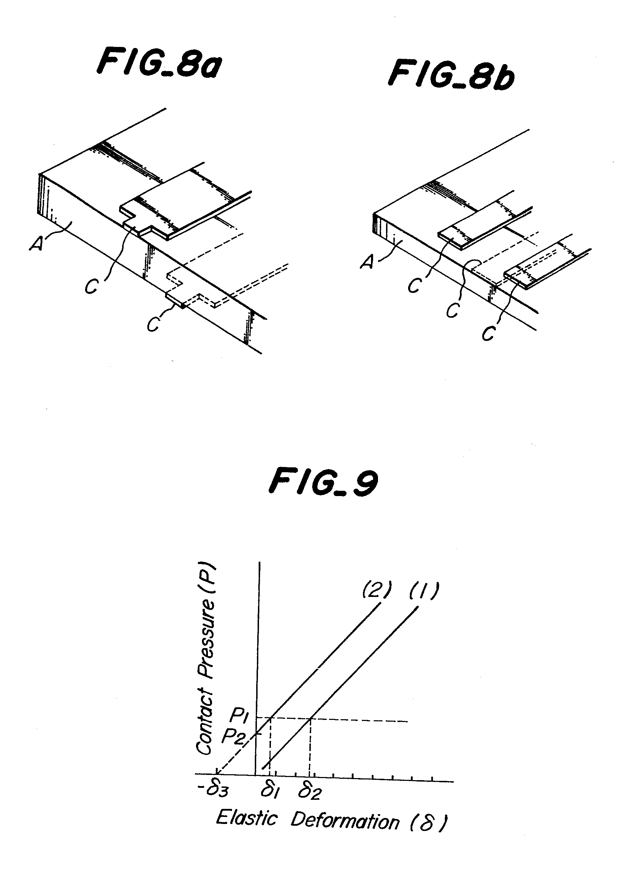

Figs. 8a and 8b illustrate modifications of the terminals according to the invention. The terminals shown in Fig. 8a have front ends which are narrowed in width so that surface insulating distances $\ell$ between the terminals on both surfaces become longer. This is particularly effective for a very thin base A. Fig. 8b illustrates the terminals whose front ends are retracted from an edge of the base A inside thereof. With this arrangement, surface insulating distances $\ell$ become longer which is no less effective than the embodiment shown in Fig. 8a.

Fig. 9 is a graph for explaining a principle of the connector according to the invention. In general, a contact pressure more than a predetermined value is required for an electrical connection in a connector. The contact pressure in a general plug type connector is obtained by elastic deformations of contacts.

The contact pressure for the electrical connection is acceptable, so long as the contact pressure is enough to remove what interrupts the movement of free electrons between contacts in contact with each other. The contact pressure is determined by factors such as kinds, thicknesses, widenesses and the like of what causes the interruptions of the movement of free electrons. For example, a very thin film of a gas (air), liquid (water), solid (metal oxide) or the like consisting of a few molecules in thickness forms what causes the interruption.

In determining an actual contacting pressure, various factors other than the above should be considered, for example, an application of a connector, voltage, current and frequency of electric energy flowing therethrough, and material, composition, configuration, dimension, working and treating methods for the contacts and the like, which are also factors for designing the contacts.

Fig. 9 illustrates the relation between the contact pressure P (ordinate) and the elastic deformation $\delta$ (abscissa). A point $P_1$ on the ordinate is the minimum contact pressure required for the electrical connection.

As shown in Fig. 9, the contact pressure of a contact is proportional to the elastic deformation. In Fig. 9, a straight line (1) is representative of a case that a contact under a free condition is subjected to an elastic deformation, while a straight line (2) is of a case that a contact is subjected to an elastic deformation starting from a condition previously elastically deformed by $-\delta_3$.

As can be seen from Fig. 9, with the contact deformed starting from the free condition, the contact pressure $P_1$ required for the electrical connection could not be obtained, unless the contact is subjected to an elastic deformation more than $\delta_2$. On the other hand, if the elastic deformation $-\delta_3$ is previously given to the contact, the contact initially includes a contact pressure $p_2$ so that the contact pressure $P_1$ required for the electrical connection can be obtained only by applying a slight deformation $\delta_1$ to the contact.

Moreover, with an insertion type connector, as the elastic deformation $\delta$ corresponds to a thickness of an IC card to be inserted into the connector, the electrical connection could be accomplished only by an IC card having a thickness at least corresponding to the deformation $\delta$ under a free condition. However, if only a contact is previously deformed by $-\delta_3$, the electrical connection could be accomplished even by an IC card having a thin thickness corresponding to the deformation $\delta$. The connector for an IC card according to the invention is realized by utilizing such a principle.

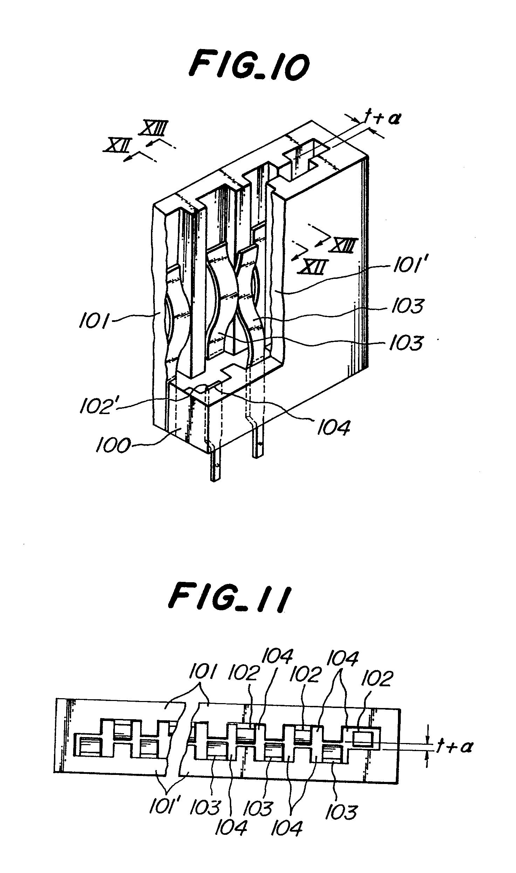

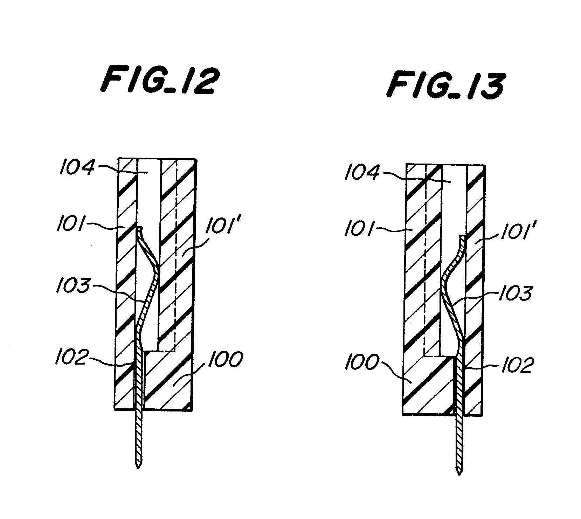

Fig. 10 illustrates a connector according to the invention in a partially removed perspective view for explaining a construction thereof. Fig. 11 is a plan view of the connector shown in Fig. 10 viewed in an inserting direction of the IC card (not shown).

Referring to Fig. 10, a connector body 100 includes side walls 101 and 101' for guiding an IC card to be inserted. Moreover, an inserting portion of the connector is formed by the side walls 101 and 101' to have a width $t+\alpha$ somewhat larger than a thickness t of the IC card to be inserted.

As shown in Figs. 10 and 11, the connector body 100 is formed with contact providing apertures 102 of a required number in two rows such that the apertures in one row are arranged between the apertures in the other row. Contacts 103 are inserted and fixed in the apertures 102, respectively. The contacts may be fixed by any publicly known method. The side walls 101 and 101' forming the inserting portion is formed with contact receiving grooves 104 at locations corresponding to the contact providing apertures 102.

The contacts 103 are inserted and fixed in the connector body 100 so that they are forced to deform at least by $-\delta_3$ as shown in Fig. 9. Therefore, the contacts are fixed in the connector body 100 with contact pressures more than $P_2$ in Fig. 9 against the opposite side walls 101 and 101' as shown in Figs. 12 and 13 which are sectional views taken along lines XII-XII and XIII-XIII in Fig. 10.

The contacts 103 used in the connector for the IC card according to the invention may be any types having shapes such as cantilever, bellows, ribbon, pin and the like or the same shapes of male and female contacts. The cantilever, bellows and ribbon type contacts are generally widely used, although these are not exclusive. The contacts 103 may be provided in the connector body 100 movably thereto as so-called "floating type contacts".

The material of the contacts 103 used for the connector for the IC card according to the invention may be any materials generally known for electrical contacts so long as they are elastic or resilient to a certain extent. They are, for example, copper and a copper alloy such as phosphor bronze, brass, beryllium-copper, Tando (JIS H3100), cadmium copper, German silver and Cu-Ni-Sn, and laminated materials consisting of one of these metals and a stainless steel having a large elasticity. If required, gold or nickel plating may be applied to the contacts.

The material of the connector body and side walls used in the invention may be any materials which are insulating and able to give contacting pressures corresponding to $-\delta_3$ to the contacts to be provided in the connector. They are, for example, natural or synthetic hard or semihard rubbers, thermosetting resins such as polyvinyl chloride, polyvinyl acetate, polystyrene, polyphenylene oxide, polyurethane, polyethylene, polypropylene polyamide, polycarbonate, polyacetal, polyvinylidene chloride, polyester, fluorine plastic and the like, and thermosetting resins such as phenol resin, urea resin, epoxy resin, alkyd resin and the like and further most of engineering plastics recently publicly used. Among these materials, polybutylene terephthalate, polycarbonate, polyamide, polyethylene terephthalate, polyacetal, and fluorine plastic are preferable.

It is further understood by those skilled in the art that the foregoing description is that of preferred embodiments of the disclosed IC card and connector and that various changes and modifications may be made in the invention without departing from the spirit and scope thereof.

**Claims**

1. An IC card including a plurality of terminals on both surfaces at one edge of the card, wherein terminals on one surface are arranged between terminals on the other surface.

2. An IC card as set forth in claim 1, wherein adjacent terminals on each surface are in a relation $P/2 > W$, where W is a width of the terminals and P is a distance between centers of the terminals.

3. An IC card as set forth in claim 1, wherein front ends of said terminals are narrowed in width to make longer surface insulating distances between said terminals on both the surfaces.

4. An IC card as set forth in claim 1, wherein front ends of said terminals are retracted from said edge of the card inside thereof to make longer surface insulating distances between said terminals on both the surfaces.

5. A connector for an IC card, said connector includes a connector body having two side walls extending from the connector body to form a guide for the IC card to be inserted into the connector and a plurality of contacts planted in two parallel rows, wherein contacts arranged in one row are between contacts arranged in the other row and the contacts are planted to be deformed before insertion of the IC card to cause contact pressures required for electrical connection with the IC card.

6. A connector for an IC card as set forth in claim 5, wherein said connector body is formed in two rows with contact providing apertures whose number corresponds to that of said contacts so that contact providing apertures in one row are between contact providing apertures in the other row, and said side walls are formed in two rows with contact receiving grooves at locations corresponding to said contact providing apertures.

0265348

**FIG_1**
PRIOR ART

**FIG_2**
PRIOR ART

**FIG_3**
PRIOR ART

**FIG_4**
PRIOR ART

0265348

**FIG_5**

**FIG_6**

**FIG_7**

0265348

## FIG. 8a

## FIG. 8b

## FIG. 9

0265348

# FIG. 10

# FIG. 11

0265348

FIG.12

FIG.13